(19) Europäisches Patentamt
European Patent Office
Office européen des brevets

(11) **EP 3 207 629 B1**

(12) **FASCICULE DE BREVET EUROPEEN**

(45) Date de publication et mention
de la délivrance du brevet:
**11.07.2018 Bulletin 2018/28**

(21) Numéro de dépôt: **15804162.4**

(22) Date de dépôt: **16.10.2015**

(51) Int Cl.:
***H02M 3/335*** *(2006.01)*

(86) Numéro de dépôt international:
**PCT/FR2015/052781**

(87) Numéro de publication internationale:
**WO 2016/059353 (21.04.2016 Gazette 2016/16)**

(54) **CONVERTISSEUR DC/DC ISOLE**

ISOLIERTER GLEICHSPANNUNGSWANDLER

ISOLATED DC/DC CONVERTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2014 FR 1459951**

(43) Date de publication de la demande:
**23.08.2017 Bulletin 2017/34**

(73) Titulaire: **Valeo Systèmes de Contrôle Moteur 95800 Cergy Saint Christophe (FR)**

(72) Inventeur: **DE SOUSA, Luis GU22 7PZ WOKING (GB)**

(74) Mandataire: **Argyma
36, rue d'Alsace Lorraine
31000 Toulouse (FR)**

(56) Documents cités:
**WO-A1-02/077738     US-B1- 7 336 056
US-B1- 8 503 199**

## Description

La présente invention concerne un convertisseur DC/DC isolé, un dispositif de conversion de tension comprenant une combinaison de convertisseurs selon l'invention, ainsi qu'un procédé de conversion de tension mis en oeuvre avec le convertisseur selon l'invention.

Les convertisseurs DC/DC (pour « direct current/direct current » en anglais) isolés peuvent présenter des commutations à zéro de tension ou ZVS (pour « zero voltage switching » en anglais) ou des commutations à zéro de courant ou ZCS (pour « zero current switching » en anglais) qui permettent de réduire les pertes par commutation lors de la conversion de tension. Ces convertisseurs sont donc particulièrement avantageux dans une application automobile où la ressource en énergie est limitée. Dans un véhicule, on peut utiliser un convertisseur de tension pour adapter des niveaux de tension entre plusieurs réseaux électriques du véhicule ou pour convertir une tension entre une source d'énergie et un consommateur électrique embarqué dans le véhicule.

On connait un convertisseur DC/DC isolé du brevet US5754413, illustré en figure 1. Le convertisseur comprend deux interrupteurs Q1, Q2 qui sont connectés en leur point milieu à une branche qui comprend deux transformateurs en série. Le convertisseur est agencé en demi-pont. Les interrupteurs contrôlent la transmission d'énergie à travers les transformateurs pour obtenir une conversion d'une tension d'entrée du convertisseur en une tension de sortie. Des diodes connectées aux secondaires des transformateurs permettent de redresser le signal de sortie. La tension de sortie est obtenue en contrôlant le rapport cyclique des interrupteurs. En modifiant le rapport cyclique pour atteindre une valeur cible de tension de sortie, on ajuste le gain du convertisseur pour atteindre la valeur cible de tension de sortie. En particulier, lorsque la tension d'entrée du convertisseur DC/DC isolé varie, il est connu de faire varier le rapport cyclique des interrupteurs du convertisseur DC/DC isolé pour réguler sa tension de sortie, c'est-à-dire maintenir sa tension de sortie à une valeur souhaitée.

Cependant, le stress en tension des diodes de redressement est fonction du rapport cyclique des interrupteurs du convertisseur. Ce stress peut devenir important lorsque le rapport cyclique devient proche de 0% ou 100%. Pour limiter le stress en tension des diodes de redressement, il est prévu, pour les deux transformateurs, des rapports de transformation respectifs qui sont différents. Mais cela complique la conception du convertisseur car les transformateurs ne peuvent pas être identiques et le courant au secondaire présente des discontinuités.

En outre, en travaillant avec un rapport cyclique variable, les ondulations de courant en sortie peuvent varier fortement entrainant une variation du rendement du convertisseur. Pour conserver un fonctionnement avec un bon rendement, le rapport cyclique doit être peu variable. Or, dans un véhicule, la tension d'une source d'énergie, telle qu'une batterie, peut varier fortement suivant l'énergie disponible. Une telle variation en entrée du convertisseur implique de faire varier le rapport cyclique de manière correspondante, ce qui limite l'utilisation du convertisseur DC/DC isolé dans un véhicule.

Il est donc recherché une solution pour améliorer les performances d'un convertisseur DC/DC isolé de façon à permettre son utilisation dans un véhicule automobile.

Afin de résoudre ce problème, l'invention concerne un convertisseur DC/DC isolé comprenant :

- un premier bras comprenant des interrupteurs en série, le premier bras étant relié à l'entrée du convertisseur ;
- un deuxième bras comprenant des interrupteurs en série ;
- une inductance connectée entre les points milieux du premier et du deuxième bras ;
- une capacité connectée entre les bornes extrémales du deuxième bras ;
- un troisième bras comprenant un composant magnétique, le troisième bras étant connecté au point milieu du deuxième bras ;

dans lequel des successions d'ouverture et de fermeture des interrupteurs permettent de convertir une tension d'entrée en une tension de sortie par l'intermédiaire du composant magnétique.

Dans le cadre de la présente demande, on entend par convertisseur isolé un convertisseur comprenant une barrière d'isolation électrique entre des éléments fonctionnels du convertisseur. Le convertisseur peut notamment comprendre un élément permettant de transmettre une énergie à travers cette barrière d'isolation.

Notamment, le premier bras est directement relié à l'entrée du convertisseur DC/DC isolé.

Le premier bras, ainsi que la capacité et l'inductance, contribuent au contrôle du transfert d'énergie à travers le composant magnétique. Par rapport à l'art antérieur, le rapport cyclique du premier bras constitue un paramètre supplémentaire dans le contrôle du transfert d'énergie à travers le composant magnétique. Ainsi, un convertisseur DC/DC isolé est obtenu dans lequel la commande peut être affinée pour améliorer les performances par rapport à l'art antérieur, notamment en ce qui concerne la transmission d'énergie par l'intermédiaire du composant magnétique. Selon un mode de réalisation, le premier bras est configuré pour contrôler la tension de sortie du convertisseur DC/DC isolé en modifiant un paramètre électrique d'un signal circulant dans l'inductance, le rapport cyclique du deuxième bras restant sensiblement constant. Le rapport cyclique des interrupteurs du deuxième bras reste donc constant à une incertitude près.

Ainsi, une valeur souhaitée de tension en sortie du convertisseur DC/DC isolé est obtenue en ajustant le paramètre électrique du signal circulant dans l'inductance. A chaque valeur de tension souhaitée en sortie du convertisseur DC/DC isolé correspond une valeur du paramètre électrique du signal circulant dans l'inductance. Une valeur de tension de sortie souhaitée en sortie du convertisseur DC/DC isolé est obtenue sans modifier le rapport cyclique du deuxième bras. Le rapport cyclique du deuxième bras peut donc être fixé à une valeur qui permet un rendement maximal du convertisseur DC/DC isolé, notamment de la transmission d'énergie à travers le composant magnétique.

A une tension de sortie donnée du convertisseur DC/DC isolé, le premier bras permet un fonctionnement du deuxième bras avec un rapport cyclique constant pour une tension d'entrée quelconque, en particulier comprise dans une gamme de fonctionnement du convertisseur DC/DC isolé. Par exemple, la différence entre la valeur minimale et la valeur maximale de la tension d'entrée du convertisseur DC/DC isolé est comprise entre 150 et 500V ; par exemple, la valeur minimale de la tension d'entrée est comprise entre 150 et 200 V ; et la valeur maximale de la tension d'entrée est comprise entre 400 et 500V, voire entre 400 et 650V.

En particulier, le premier bras est configuré pour modifier le paramètre électrique du signal circulant dans l'inductance par une modification de son propre rapport cyclique.

Selon une variante de ce mode de réalisation, le deuxième bras est configuré de sorte que son rapport cyclique est sensiblement égal à 50%. A un rapport cyclique de 50% dans le deuxième bras, le courant en sortie du convertisseur DC/DC isolé, plus particulièrement en sortie du composant magnétique, présente des ondulations (« ripples » en anglais) qui sont faibles car les ondulations des courants dans des inductances magnétisantes du convertisseur DC/DC isolé, en particulier celles du composant magnétique, sont compensées.

Selon un mode de réalisation, le convertisseur comprend un circuit destiné à implémenter une première boucle de façon à asservir une consigne d'un paramètre électrique d'un signal parcourant l'inductance connectée entre les premier et deuxième bras à une différence entre la valeur de la tension de sortie du convertisseur DC/DC isolé et une consigne de tension de sortie du convertisseur DC/DC isolé.

Selon une variante, le convertisseur comprend un circuit destiné à implémenter une deuxième boucle de façon à asservir le paramètre électrique du signal parcourant l'inductance connectée entre les premier et deuxième bras à une différence entre la valeur du paramètre électrique et la consigne du paramètre électrique.

Selon une variante, le paramètre électrique du signal est un courant ou une tension. Ainsi, dans une variante particulière, le circuit est destiné à implémenter la première boucle de façon à asservir le courant parcourant l'inductance connectée entre les premier et deuxième bras à une différence entre la valeur de la tension de sortie du convertisseur DC/DC isolé et une consigne de tension de sortie du convertisseur DC/DC isolé.

En particulier, le circuit de la première boucle et/ou de la deuxième boucle asservissent le paramètre électrique en asservissant les interrupteurs du premier bras, notamment en asservissant un rapport cyclique d'ouverture ou de fermeture des interrupteurs.

Selon un mode de réalisation, le composant magnétique comporte un circuit primaire et un circuit secondaire séparés par une barrière d'isolation électrique, ledit composant magnétique étant configuré pour, lors de la conversion d'une tension d'entrée du convertisseur DC/DC isolé en une tension de sortie, fonctionner comme un transformateur du circuit primaire vers le circuit secondaire et comme une impédance qui stocke de l'énergie au niveau du circuit primaire.

En particulier, la tension de sortie du convertisseur DC/DC isolé est prise aux bornes du circuit secondaire du composant magnétique.

Selon un mode de réalisation, le composant magnétique est configuré pour que :

- sur une première partie d'une période de fonctionnement du convertisseur, une première partie du circuit primaire transfère une énergie vers une première partie du circuit secondaire et une deuxième partie du circuit primaire réalise une inductance stockant de l'énergie ;
- sur une deuxième partie de la période de fonctionnement du convertisseur, la deuxième partie du circuit primaire transfère une énergie vers une deuxième partie du circuit secondaire, et la première partie du circuit primaire réalise une inductance stockant de l'énergie.

En particulier, le deuxième bras est commandé en modulation par largeur d'impulsion ; la première partie de période de fonctionnement correspond à une première partie de la période de modulation ; et la deuxième partie de la période de fonctionnement correspond à une deuxième partie de la période de modulation. Ces première et deuxième parties sont notamment déterminées par le rapport cyclique du deuxième bras.

Selon une variante, le circuit primaire du composant magnétique comprend un enroulement primaire et le circuit secondaire du composant magnétique comprend au moins un premier enroulement secondaire et au moins un deuxième enroulement secondaire non couplés magnétiquement entre eux, lesdits premier et deuxième enroulements secondaires étant couplés magnétiquement à l'enroulement primaire. Il faut comprendre que le circuit secondaire comprend au moins un enroulement primaire, au moins un premier enroulement primaire et au moins un deuxième enroulement secondaire. En particulier, le circuit primaire du composant magnétique comprend un seul enroulement primaire. Notamment, l'enroulement primaire est relié au point milieu du deuxième bras.

En particulier, la tension de sortie du convertisseur DC/DC isolé est prise aux bornes du ou des premiers enroulements secondaires et/ou du ou des deuxièmes enroulements secondaires.

Selon une variante particulière, le composant magnétique est configuré pour agir d'une part comme un transformateur depuis l'enroulement primaire vers les enroulements secondaires, notamment d'une partie de l'enroulement primaire vers les enroulements secondaires ; et d'autre part comme une impédance qui stocke de l'énergie au niveau de l'enroulement primaire, notamment au niveau d'une autre partie de l'enroulement primaire.

En particulier, le composant magnétique est configuré pour agir comme un transformateur depuis l'enroulement primaire, notamment depuis une partie de l'enroulement primaire, soit vers le ou les premiers enroulements secondaires, soit vers le ou les deuxièmes enroulements secondaires ; tout en fonctionnant comme une impédance qui stocke de l'énergie au niveau de l'enroulement primaire, notamment au niveau d'une autre partie de l'enroulement primaire.

Selon une variante particulière, l'enroulement secondaire vers lequel le composant magnétique agit comme un transformateur dépend de la tension fournie au niveau de l'enroulement primaire. Autrement dit, en fonction de la tension fournie au niveau de l'enroulement primaire, le composant magnétique fonctionne comme un transformateur soit vers le ou les premiers enroulements secondaires, soit vers le ou les deuxièmes enroulements secondaires.

Selon une variante, le composant magnétique comprend au moins un premier et un deuxième transformateurs en série dans lesquels :

- le primaire du premier transformateur forme la première partie du circuit primaire et le secondaire du premier transformateur forme la première partie du circuit secondaire ;
- le primaire du deuxième transformateur forme la deuxième partie du circuit primaire et le secondaire du deuxième transformateur forme la deuxième partie du circuit secondaire.

En particulier, les primaires des transformateurs sont en série et reliés au point milieu du deuxième bras. En particulier, la tension de sortie du convertisseur DC/DC isolé est prise aux bornes du ou des secondaires du premier transformateur et/ou du deuxième transformateur.

Selon un mode de réalisation, le deuxième bras et le composant magnétique, notamment le circuit primaire du composant magnétique, forment une structure en demi-pont. En particulier, le troisième bras comprenant le composant magnétique est connecté d'une part au point milieu du deuxième bras et d'autre part à une masse du convertisseur DC/DC isolé.

Alternativement, le deuxième bras et le composant magnétique, notamment le circuit primaire du composant magnétique, forment une structure en pont complet avec d'autres interrupteurs. En particulier, le troisième bras comprenant le composant magnétique est connecté d'une part au point milieu du deuxième bras et d'autre part au point milieu d'un quatrième bras comprenant des interrupteurs en série.

Selon un mode de réalisation, au moins un des interrupteurs comprend une capacité en parallèle, notamment les interrupteurs du deuxième et/ou du quatrième bras.

L'invention concerne en outre un dispositif de conversion de tension comprenant une combinaison d'au moins deux convertisseurs DC/DC isolés selon l'invention ; et dans lequel les premiers bras respectifs des convertisseurs DC/DC isolés sont configurés pour fonctionner avec un déphasage de $2\pi/n$, et les deuxièmes bras respectifs des convertisseurs sont configurés pour fonctionner avec un déphasage de $\pi/n$, n étant le nombre de convertisseurs DC/DC isolés.

En particulier, les au moins deux convertisseurs DC/DC isolés du dispositif sont entrelacés.

Selon un mode de réalisation, les convertisseurs DC/DC isolés partagent un seul circuit destiné à implémenter la première boucle, de sorte que les premiers bras respectifs des convertisseurs DC/DC isolés reçoivent la même consigne.

L'invention concerne également un procédé de conversion de tension comprenant les étapes consistant à :

- fournir au moins un convertisseur DC/DC isolé selon l'invention ;
- réaliser des successions d'ouverture et de fermeture des interrupteurs permettant de convertir une tension d'entrée en une tension de sortie par l'intermédiaire du composant magnétique du convertisseur DC/DC isolé.

Selon un mode de réalisation, la réalisation des successions d'ouverture et de fermeture des interrupteurs comprend la modification d'un paramètre électrique d'un signal parcourant l'inductance, le rapport cyclique du deuxième bras restant sensiblement constant. Le rapport cyclique des interrupteurs du deuxième bras reste donc constant à une incertitude près.

En particulier, la modification d'un paramètre électrique d'un signal circulant dans l'inductance comprend la modification du rapport cyclique du premier bras.

Selon un mode de réalisation, le rapport cyclique du deuxième bras est sensiblement égal à 50%.

Selon un mode de réalisation, la conversion de la tension d'entrée en tension de sortie comprend une première boucle asservissant la consigne d'un paramètre électrique d'un signal parcourant le premier bras à une différence entre la valeur de la tension de sortie du convertisseur DC/DC isolé et une consigne de tension de sortie du convertisseur DC/DC isolé.

Selon un mode de réalisation, le procédé comprend la fourniture d'une pluralité de convertisseurs DC/DC isolés ; et le procédé est tel que :

- les deuxièmes bras respectifs des convertisseurs DC/DC isolés fonctionnent avec un déphasage de $\pi/n$, n étant le nombre de convertisseurs DC/DC isolés ; et
- les premiers bras respectifs des convertisseurs DC/DC isolés fonctionnent avec un déphasage de $2\pi/n$.

Selon un mode de réalisation, la conversion de la tension d'entrée en tension de sortie est réalisée avec la même consigne délivrée par un seul premier bras partagé entre les convertisseurs DC/DC isolés.

Le procédé selon l'invention peut comprendre l'une des caractéristiques décrites précédemment en relation avec le convertisseur DC/DC isolé selon l'invention.

L'invention sera mieux comprise en faisant référence aux dessins, dans lesquels :

- la figure 1 illustre un exemple de convertisseur DC/DC isolé selon l'art antérieur ;
- les figures 2 et 3 illustrent chacune un exemple de convertisseur DC/DC isolé selon l'invention ;
- la figure 4 illustre un exemple de procédé de commande d'un dispositif de conversion comprenant un entrelacement de convertisseurs selon l'invention ;
- la figure 5 illustre une variante du composant magnétique du convertisseur des figures 2 ou 3 ;
- les figures 6a à 6e illustrent des exemples de réalisation du composant magnétique illustré en figure 5.

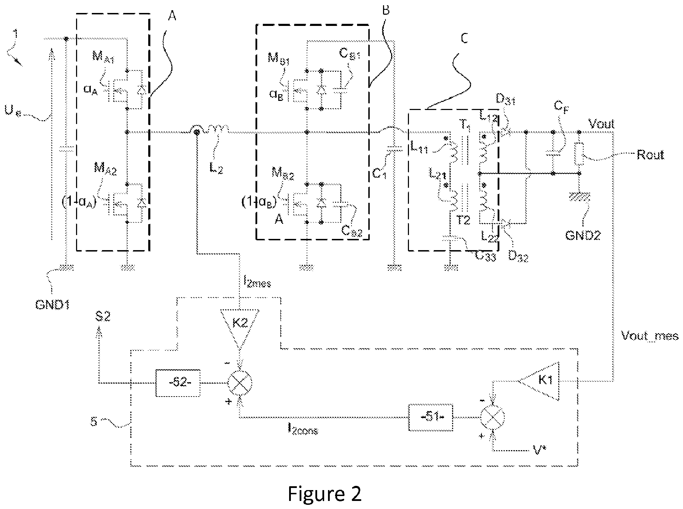

Le convertisseur selon l'invention sera mieux compris en faisant référence à la figure 2 qui présente un exemple de convertisseur DC/DC isolé selon l'invention..

Le convertisseur DC/DC isolé 1 comprend un premier bras A d'interrupteurs en série et un deuxième bras B d'interrupteurs en série. Les bras A, B comprennent des interrupteurs MA1, MA2, MB1, MB2 dont une succession d'ouvertures et de fermetures permet de contrôler la sortie du convertisseur DC/DC isolé 1. Ces interrupteurs peuvent être des transistors, tels que des transistors MOSFET, IGBT, ou autres. Une partie, notamment les interrupteurs du deuxième bras, ou la totalité du convertisseur DC/DC isolé 1 peut être réalisé à partir d'un matériau semiconducteur tel que du silicium (Si), du nitrure de gallium (GaN), du carbure de silicium (SiC), ou tout autre matériau semiconducteur.

Le premier bras A comprend deux interrupteurs MA1, MA2 en série. L'interrupteur MA1, dit interrupteur côté haut, est connecté à la borne haute d'une source de tension (non représentée). L'interrupteur MA2, dit interrupteur côté bas, est connecté à la borne basse de la source de tension. Cette borne basse correspond notamment à une première masse GND1 du convertisseur DC/DC isolé 1. Chaque interrupteur MA1, MA2, peut comprendre un transistor en parallèle avec une diode de roue libre.

Une inductance L2 a une première borne connectée au point milieu des deux interrupteurs MA1, MA2 du premier bras A, et une deuxième borne connectée au point milieu du deuxième bras B.

Le deuxième bras B comprend deux interrupteurs MB1, MB2 en série, de préférence identiques. Les interrupteurs MB1, MB2 comprennent des diodes similaires aux diodes décrites précédemment pour les interrupteurs MA1, MA2 du premier bras A. En outre, chaque interrupteur MB1, MB2 comprend une capacité CB1, CB2 en parallèle. Ces capacités CB1, CB2 servent à faire une commutation à zéro de tension ou ZVS (pour « Zero Voltage Switching » en anglais) lors de l'ouverture des interrupteurs MB1, MB2. Pendant l'ouverture d'un interrupteur MB1, MB2 on récupère l'énergie stockée dans une inductance, notamment une inductance de fuite d'un composant magnétique décrit par la suite, pour décharger la capacité CB1, CB2 qui est aux bornes de l'interrupteur. Une fois que la tension est proche de 0V on vient commander l'interrupteur et ainsi on réalise une commutation sous zéro de tension, ce qui réduit fortement les pertes en commutation. Ces capacités CB1, CB2 peuvent être intrinsèquement présentes dans la structure du semi-conducteur composant les interrupteurs MB1, MB2, en tant qu'éléments parasites. Les capacités parasites des interrupteurs MB1, MB2 peuvent donc suffire pour réaliser la commutation à zéro de tension sans ajout de capacité supplémentaires. Le premier bras A pourrait comprendre également des capacités pour une commutation douce des ses interrupteurs MA1, MA2. Cependant, ceci imposerait des ondulations de courant dans l'inductance L2 susceptibles d'entrainer des pertes. Si bien que l'avantage de la commutation douce des interrupteurs MA1, MA2 du premier bras A serait perdu.

Une capacité C1 est connectée entre les bornes extrémales du deuxième bras B. En particulier, la capacité C1 est connectée à l'interrupteur côté haut MB1 du deuxième bras B et à l'interrupteur côté bas MB2 du deuxième bras, à une borne respective qui est différente du point milieu du deuxième bras B.

Le point milieu entre les deux interrupteurs MB1, MB2 du deuxième bras B est connecté à un troisième bras C qui comprend deux transformateurs d'isolation T1, T2 en série. Chaque transformateur T1, T2 comprend un primaire L11, L21 et un secondaire L12, L22. Les primaires L11, L21 et les secondaires L12, L22 sont respectivement en série. Le point milieu des interrupteurs MB1, MB2 est connecté aux primaires L11, L21. Une capacité C33 est en série avec les transformateurs T1, T2. Cependant le convertisseur DC/DC isolé 1 pourrait se passer de ce condensateur. La capacité C33 permet de supprimer la composante continue du signal transmis par les transformateurs T1, T2, notamment dans le cas d'une structure en demi-pont. La capacité C33 peut être supprimée dans une structure en pont complet. Les secondaires L12, L22 sont en série, avec leur point milieu connecté à une deuxième masse GND2 du convertisseur DC/DC isolé 1.

Des diodes D31, D32 sont connectées aux secondaires L12, L22 pour redresser le signal issu des transformateurs T1, T2. A cet effet, une diode D31 a son anode connectée à une borne d'un secondaire L12 et l'autre diode D32 a son anode connectée à une borne de l'autre secondaire L22, ces bornes étant différentes du point milieu des deux secondaires L12, L22. La sortie du convertisseur DC/DC isolé 1 est prise entre la borne des diodes D31, D32 qui n'est pas connectée aux secondaires L12, L22 et qui est commune aux deux diodes D31, D32 et la deuxième masse GND2. La sortie haute est donc prise à la borne commune des diodes D31, D32.

Dans une variante, chaque diode D31, D32 a sa cathode respective connectée à une borne du secondaire L12, L22 différente du point milieu. La sortie haute est prise au point milieu des secondaires L12, L22. Le point milieu des secondaires L12, L22 n'est donc pas connecté à la deuxième masse GND2. La borne commune aux deux diodes D31, D32 est reliée à la deuxième masse GND2.

Les diodes D31, D32 pourraient être avantageusement remplacées par des interrupteurs, notamment des transistors, tels que des transistors MOSFET, IGBT ou autres, afin d'obtenir par exemple un redressement synchrone en sortie des transformateurs T1, T2. Pour des applications à fort courant au secondaire l'usage de transistors à la place des diodes permet d'améliorer le rendement global du convertisseur DC/DC isolé 1.

Le convertisseur DC/DC isolé 1 comprend une capacité CF pour filtrer le signal de sortie.

Les interrupteurs MB1, MB2 du deuxième bras B ont un rapport cyclique qui permet de transférer une énergie à travers les transformateurs T1, T2. En particulier, sur une première partie d'une période de fonctionnement, l'interrupteur MB1 est fermé et l'interrupteur MB2 est ouvert. Une inductance magnétisante du primaire L11 du premier transformateur T1 stocke de l'énergie et le primaire L21 du deuxième transformateur T2 transfère une énergie vers le secondaire L22 du deuxième transformateur T2.

Sur une deuxième partie de la période de fonctionnement, Une inductance magnétisante du primaire L21 du deuxième transformateur T2 stocke de l'énergie, et le primaire L11 du premier transformateur T1 transfère une énergie vers le secondaire L12 du premier transformateur T1. Les durées des première et deuxième parties de fonctionnement sont définies par le rapport cyclique des interrupteurs MB1, MB2.

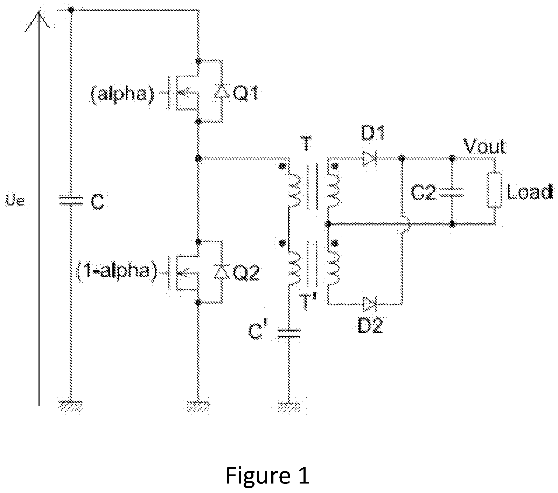

Dans l'art antérieur illustré en figure 1, la transmission d'énergie à travers les transformateurs T1, T2 est contrôlée par les interrupteurs Q1, Q2 en série. Dans le convertisseur DC/DC isolé selon l'invention, le deuxième bras B permet également de contrôler cette transmission d'énergie. Cependant, dans l'art antérieur, la tension aux bornes de la branche comprenant les deux interrupteurs Q1, Q2 est égale à la tension d'entrée Ue du convertisseur. Alors que, dans le convertisseur DC/DC isolé 1 selon l'invention, la tension VC1 aux bornes de la deuxième branche B, c'est-à-dire aux bornes de la capacité C1, est donnée par l'expression

$$VC1 = \frac{\alpha_A}{\alpha_B} \times Ue,$$

où $\alpha_A$ est le rapport cyclique du premier bras A et $\alpha_B$ est le rapport cyclique du deuxième bras B.

Ainsi, dans le convertisseur DC/DC isolé 1, le rapport cyclique $\alpha_A$ du premier bras A constitue, par rapport à l'art antérieur, un paramètre supplémentaire dans le contrôle du transfert d'énergie à travers les transformateurs T1, T2. La commande du convertisseur DC/DC isolé 1 est donc affinée par rapport à l'art antérieur.

En outre, la plage de valeur accessible par la tension VC1 aux bornes de la deuxième branche B est supérieure à la plage de valeur accessible par la tension aux bornes de la branche des interrupteurs Q1, Q2 dans l'art antérieur. En effet, si le rapport $\alpha_A/\alpha_B$ est supérieur à 1, alors la tension VC1 aux bornes de la deuxième branche B est supérieure à la tension d'entrée Ue. En particulier, la tension VC1 peut être supérieure à une valeur maximale $Ue_{max}$ de la tension d'entrée Ue. La tension VC1 aux bornes de la branche B peut donc être plus élevée que la tension d'entrée Ue du convertisseur DC/DC isolé 1, contrairement à l'art antérieur. De même, si le rapport $\alpha_A/\alpha_B$ est inférieur à 1, alors la tension VC1 aux bornes de la deuxième branche B est inférieure à la tension d'entrée Ue. En particulier, la tension VC1 peut être inférieure à une valeur minimale $Ue_{min}$ de la tension d'entrée Ue. La tension VC1 aux bornes de la deuxième branche B peut donc être plus faible que la tension d'entrée Ue du convertisseur DC/DC isolé, contrairement à l'art antérieur.

On peut noter que cette propriété d'abaisser ou d'élever la tension d'entrée peut être réalisée en rajoutant un étage supplémentaire au convertisseur de l'art antérieur illustré en figure 1. Par exemple, l'étage supplémentaire peut être un convertisseur élévateur - abaisseur (« buck-boost » en anglais) relié au côté primaire du convertisseur. Le convertisseur obtenu comporterait donc deux bras d'interrupteurs supplémentaires par rapport au bras d'interrupteurs Q1, Q2. Le nombre total de bras d'interrupteurs serait donc de 3 côté primaire du convertisseur. Alors que, dans le convertisseur selon l'invention, la propriété d'abaisser ou d'élever la tension d'entrée est obtenue avec deux bras A, B d'interrupteurs MA1, MA2, MB1, MB2 côté primaire du convertisseur 1.

En particulier, les interrupteurs MB1, MB2 du deuxième bras B fonctionnent avec un rapport cyclique $\alpha_B$ qui ne varie pas, c'est-à-dire qui reste constant au cours du temps. Lors du fonctionnement du convertisseur DC/DC isolé 1, la tension de sortie Vout est contrôlée par le courant circulant dans l'inductance L2. Ce courant est commandé par le premier bras A. A cet effet, le convertisseur DC/DC isolé 1 comprend une unité de commande 5 du premier bras A. L'unité de commande 5 délivre un signal S2 de modulation en largeur d'impulsion ou PWM (pour « pulse width modulation » en anglais) qui commande l'ouverture et la fermeture des interrupteurs MA1, MA2 du premier bras A pour contrôler le courant circulant dans l'inductance L2. Les interrupteurs MA1, MA2 du premier bras A sont commandés de sorte que le courant circulant dans l'inductance L2 permette d'obtenir une valeur de tension souhaitée en sortie du convertisseur DC/DC isolé 1. Ainsi, contrairement à l'art antérieur, il n'est pas nécessaire de faire varier le rapport cyclique $\alpha_B$ des interrupteurs MB1, MB2 connectés aux transformateurs T1, T2. Le deuxième bras B peut donc fonctionner à son rapport cyclique $\alpha_B$ le plus avantageux pour la transmission d'énergie par les transformateurs T1, T2, notamment à 50%.

Les stress en tension aux bornes des diodes D31, D32 sont fonction du rapport cyclique $\alpha_B$ du deuxième bras B, et sont donnés par les expressions suivantes :

$$V(D31) = Vout/(1 - \alpha_B) \text{ et } V(D32) = Vout/ \alpha_B$$

Le rapport cyclique $\alpha_B$ est de préférence égal à 50%. Ainsi, les stress en tension aux bornes de deux diodes D31, D32 sont égaux, l'usure est la même entre les diodes D31, D32. En outre, à un rapport cyclique de 50%, les ondulations de courant dues aux inductances magnétisantes des transformateurs T1,T2 sont compensées entre elles. Ainsi, le courant aux secondaires L12, L22 est continu.

La tension VC1 aux bornes de la deuxième branche B est alors égale à $2\alpha_A$Ue. Avec le rapport cyclique $\alpha_A$ du premier bras A, on peut faire varier la tension VC1 aux bornes du deuxième bras B. Si le rapport cyclique $\alpha_A$ du premier bras A est inférieur à 0,5, la tension VC1 aux bornes du deuxième bras B est inférieure à 2Ue. Si le rapport cyclique $\alpha_A$ du premier bras A est supérieur à 0,5, la tension VC1 aux bornes du deuxième bras B est supérieure à 2Ue. Un rapport cyclique $\alpha_B$ de 0,5 pour le deuxième bras B permet donc un contrôle simple du convertisseur DC/DC isolé 1.

En particulier, lorsque la tension d'entrée Ue du convertisseur de tension 1 varie, le premier bras A permet de s'assurer que la tension de sortie Vout garde une valeur désirée. Ainsi, si la tension d'entrée Ue du convertisseur DC/DC isolé 1 change de valeur, l'unité de commande 5 modifie de façon correspondante la commande des rapports cycliques $\alpha_A$ des interrupteurs MA1, MA2 du premier bras A pour maintenir le courant parcourant la bobine L2 à une valeur souhaitée. Ceci est particulièrement avantageux dans un véhicule électrique où le niveau de charge d'une batterie peut varier au cours du temps.

Plus particulièrement, l'unité de commande 5 réalise une première boucle d'asservissement du courant parcourant l'inductance connectée entre les premier A et deuxième bras B à une différence entre la valeur Vout_mes de la tension de sortie du convertisseur DC/DC isolé 1 et une tension Vout souhaitée en sortie du convertisseur DC/DC isolé 1. A cet effet, l'unité de commande 5 reçoit la tension Vout mes mesurée en sortie du convertisseur DC/DC isolé 1, éventuellement multipliée par un gain K1. L'unité de commande 5 compare ensuite une consigne de tension V* avec la tension Vout mes mesurée. La consigne de tension V* correspond à la tension Vout souhaitée en sortie du convertisseur DC/DC isolé 1. En fonction du résultat de la comparaison, un contrôleur 51 délivre au premier bras A une consigne de courant I2cons devant parcourir l'inductance L2.

La consigne de courant I2cons peut être transmise directement à un contrôleur 52 qui délivre au premier bras A le signal PWM S2 à partir de la consigne de courant I2cons. Cependant, l'unité de commande 5 peut réaliser une deuxième boucle qui asservit le courant parcourant l'inductance L2 à une différence entre la valeur I2mes du courant parcourant l'inductance L2 et la consigne de courant I2cons. En particulier, l'unité de commande 5 compare la consigne de courant I2cons issue de la première boucle avec le courant I2mes mesuré sur l'inductance L2. Le courant I2cons est éventuellement multiplié par un gain K2 avant la comparaison. En fonction du résultat de cette comparaison, le contrôleur 52 détermine le signal S2 de commande du rapport cyclique $\alpha_A$ des interrupteurs MA1, MA2 du premier bras A, de façon à ajuster le courant parcourant l'inductance L2. Des boucles de tension pourraient être utilisées. Cependant, la boucle de courant est plus facile à mettre en oeuvre car, en petit signal, la boucle de courant permet d'avoir une fonction de transfert du premier ordre alors que la boucle de tension est du deuxième ordre. En outre, le convertisseur DC/DC isolé 1 pourrait mettre en oeuvre la première boucle sans utiliser la deuxième boucle.

Le convertisseur DC/DC isolé 1 selon l'invention peut être conçu pour couvrir une gamme de fonctionnement. La gamme de fonctionnement correspond à une tension d'entrée Ue du convertisseur DC/DC isolé 1 comprise entre une valeur minimale $Ue_{min1}$ et une valeur maximale $Ue_{max1}$ ; et à une tension de sortie Vout comprise entre une valeur minimale $Vout_{min1}$ et une valeur maximale $Vout_{max1}$. Par exemple, la tension d'entrée Ue est comprise entre 170 et 450V ; et la tension cible Vout en sortie du convertisseur DC/DC isolé est comprise entre 12 et 16V. Par exemple, la valeur minimale $Vout_{min1}$ de la tension de sortie est comprise entre 8 et 14V et la valeur maximale $Vout_{max1}$ de la tension de sortie est comprise entre 15 et 16V.

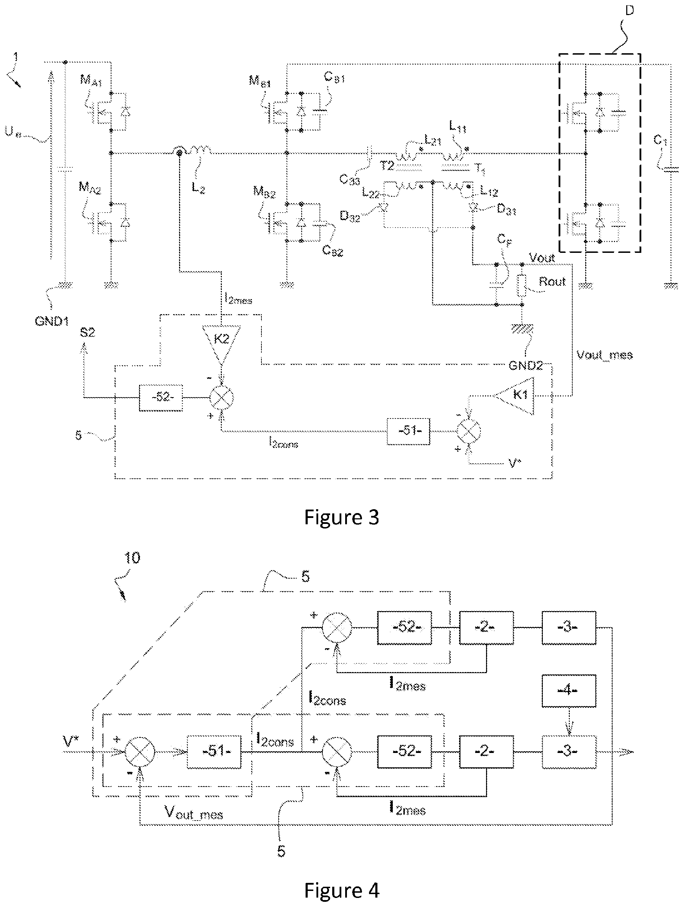

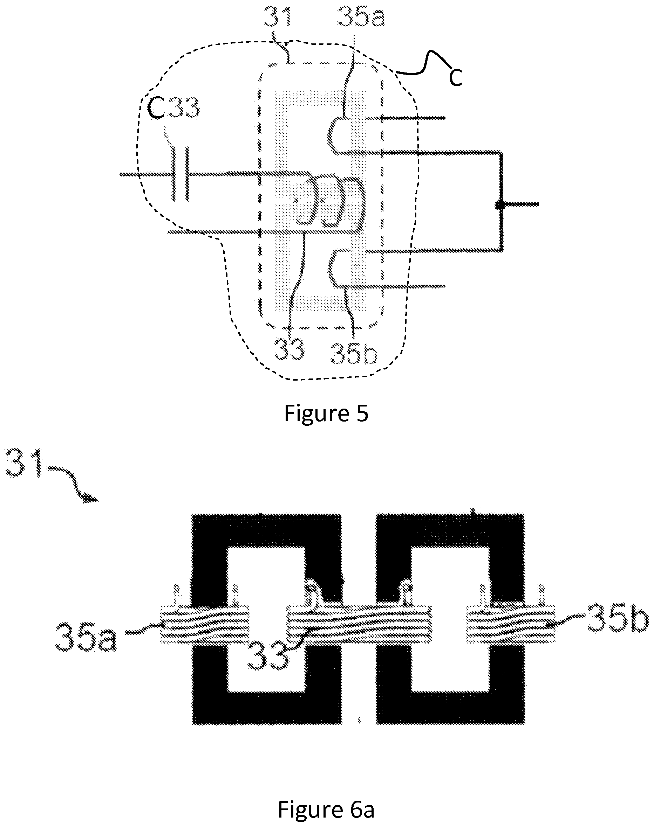

Dans les exemples illustrés en figures 2 et 3, le composant magnétique du convertisseur DC/DC isolé 1 comprend un premier T1 et un deuxième T2 transformateurs en série. Le composant magnétique peut être remplacé par un composant magnétique 31 illustré en figure 5. Le composant magnétique 31 comprend un circuit primaire avec un seul enroulement primaire 33 relié à la capacité C33 et un circuit secondaire avec deux enroulements secondaires 35a et 35b. Les deux enroulements secondaires 35a et 35b sont couplés magnétiquement à l'enroulement primaire 33 mais ne sont pas couplés magnétiquement entre eux. Un tel composant magnétique 31 permet non seulement de réduire le coût du convertisseur en réduisant le nombre de composants comprenant de la ferrite, mais aussi de réduire l'encombrement du convertisseur en permettant d'obtenir un convertisseur plus compact.

Le fonctionnement du convertisseur DC/DC isolé 1 reste le même. Le composant magnétique 31 fonctionne d'une manière similaire à deux transformateurs parfaits en série. Sur la première partie de la période de modulation, une première partie de l'enroulement primaire 33 réalise une inductance, et une deuxième partie de l'enroulement primaire 33 transfère l'énergie vers le deuxième enroulement secondaire 35a. Sur la deuxième partie de la période de modulation, la première partie de l'enroulement primaire 33 transfère l'énergie vers le premier secondaire 35b, et la deuxième partie de l'enroulement primaire 33 réalise une inductance.

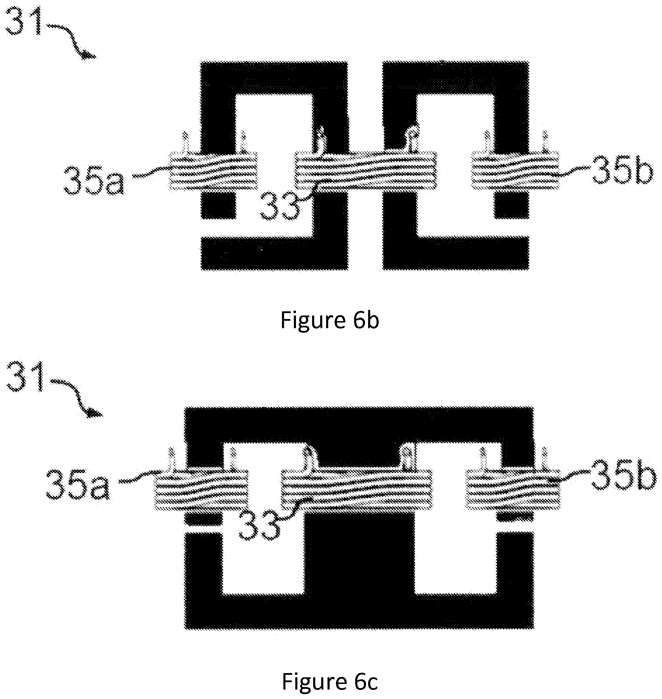

Différentes configurations permettant d'obtenir un composant magnétique 31 permettant un couplage magnétique entre l'enroulement primaire 33 et les enroulements secondaires 35a et 35b sans qu'il n'y ait de couplage magnétique entre les enroulements secondaires 35a et 35b sont illustrés en figures 6a à 6c.

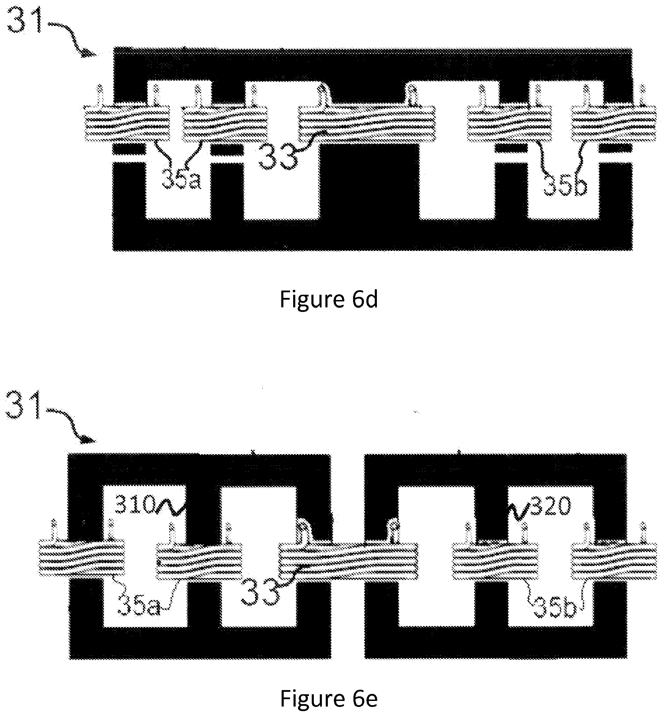

Les figures 6d, 6e illustrent des exemples de composant magnétique 31 qui comprennent au moins deux premiers enroulements secondaires 35a en parallèle et au moins deux deuxièmes enroulements secondaires 35b en parallèle. Ces configurations sont avantageuses dans des applications où le courant circulant dans le convertisseur DC/DC isolé 1 est élevé, par exemple supérieur à 100A, voire supérieur à 200A. Le convertisseur DC/DC isolé 1 comprend alors plusieurs diodes D31, chacune connectée à un premier enroulement secondaire 35a respectif ; et plusieurs diodes D32, chacune connectée à un deuxième enroulement secondaire 35b respectif. Comme dans les exemples illustrés en figures 2 et 3, les diodes D31, D32 pourraient être remplacées par des interrupteurs.

Les composants 31 illustrés en figures 6a à 6e sont décrits plus avant dans la demande de brevet français 1458573 dont le contenu est incorporé à la présente demande.

Dans l'exemple illustré en figure 2, le deuxième bras B et les primaires des transformateurs T1, T2 forment une structure en demi-pont. L'exemple illustré en figure 3 est identique à l'exemple de la figure 2 si ce n'est que, dans la figure 3, le deuxième bras B et les primaires des transformateurs T1, T2 forment une structure en pont complet avec un quatrième bras D. Les interrupteurs du quatrième bras D sont de préférence identiques à ceux du deuxième bras B.

Pour des applications de puissance, il peut être avantageux de combiner plusieurs des convertisseurs DC/DC isolés 1 illustrés en figures 2 et 3. On peut mettre des convertisseurs DC/DC isolés 1 en parallèle et les combiner afin de limiter les ondulations de courant et réduire la valeur de la capacité de filtrage CF en sortie du convertisseur DC/DC isolé 1. Dans chaque convertisseur DC/DC isolé 1, grâce au premier bras A, le rapport cyclique $\alpha_B$ du deuxième bras B reste constant.

La figure 4 illustre un fonctionnement d'un dispositif de conversion 10 qui comprend une combinaison de convertisseurs DC/DC isolés 1. De préférence, la première boucle d'asservissement est commune à tous les convertisseurs DC/DC isolés 1. Ainsi, les premiers bras A reçoivent la même consigne de courant I2cons. A cet effet, le dispositif 10 peut comprendre un seul contrôleur 51 délivrant une seule consigne de courant I2cons à tous les premiers bras A des convertisseurs DC/DC isolés 1. Ainsi, un équilibrage en courant entre les convertisseurs est assuré.

De préférence, les convertisseurs DC/DC isolés 1 fonctionnent avec un déphasage. En particulier, les premiers bras A fonctionnent avec un déphasage de $2\pi/n$, où n est le nombre de convertisseurs DC/DC isolés 1, qui permet de limiter les fluctuations en sortie du dispositif 10 et les problèmes de compatibilité électromagnétique. Les deuxièmes bras B des convertisseurs DC/DC isolés 1 fonctionnent avec un déphasage de $\pi/n$ qui permet de limiter les ondulations en sortie du dispositif 10. Ces ondulations peuvent être causées par éléments parasites, telles que des inductances parasites côté primaire ou secondaire.

L'invention n'est pas limitée aux exemples décrits. En particulier, les boucles de tension peuvent être remplacées par des boucles de courant. Le convertisseur DC/DC isolé peut aussi être utilisé dans un convertisseur alternatif-continu configuré pour convertir une tension alternative en une tension continue ou inversement, ou dans un convertisseur alternatif-alternatif. Avantageusement, le convertisseur DC/DC isolé est alors complété par un convertisseur alternatif-continu en amont du premier bras et/ou un convertisseur continu-alternatif en aval du convertisseur DC/DC isolé.

## Revendications

1. Convertisseur DC/DC isolé (1) comprenant :

    - un premier bras (A) comprenant des interrupteurs (MA1, MA2) en série, le premier bras (A) étant relié à l'entrée du convertisseur ;
    - un deuxième bras (B) comprenant des interrupteurs (MB1, MB2) en série ;
    - une inductance (L2) connectée entre les points milieux du premier (A) et du deuxième bras (B) ;
    - une capacité (C1) connectée entre les bornes extrémales du deuxième bras

- un troisième bras (C) comprenant un composant magnétique (31), le troisième bras (C) étant connecté au point milieu du deuxième bras (B) ;

dans lequel des successions d'ouverture et de fermeture des interrupteurs (MA1, MA2, MB1, MB2) permettent de convertir une tension d'entrée (Ue) en une tension de sortie (Vout) par l'intermédiaire du composant magnétique (31).

2. Convertisseur (1) selon la revendication 1, dans lequel le premier bras (A) est configuré pour contrôler la tension de sortie (Vout) du convertisseur DC/DC isolé (1) en modifiant un paramètre électrique d'un signal parcourant l'inductance (L2), le rapport cyclique ($\alpha_B$) du deuxième bras (B) restant sensiblement constant.

3. Convertisseur (1) selon la revendication précédente, dans lequel le deuxième bras (B) est configuré de sorte que son rapport cyclique ($\alpha_B$) est sensiblement égal à 50%.

4. Convertisseur (1) selon l'une des revendications précédentes, comprenant un circuit (5) destiné à implémenter une première boucle de façon à asservir une consigne (I2cons) d'un paramètre électrique d'un signal parcourant l'inductance (L2) connectée entre les premier et deuxième bras (B) à une différence entre la valeur (Vout_mes) de la tension de sortie du convertisseur DC/DC isolé (1) et une consigne (V*) de tension de sortie du convertisseur DC/DC isolé (1).

5. Convertisseur (1) selon l'une des revendications précédentes, dans lequel le composant magnétique comporte un circuit primaire et un circuit secondaire séparés par une barrière d'isolation électrique, ledit composant magnétique étant configuré pour, lors de la conversion d'une tension d'entrée (Ue) du convertisseur DC/DC isolé (1) en une tension de sortie (Uout), fonctionner comme un transformateur du circuit primaire vers le circuit secondaire et comme une impédance qui stocke de l'énergie au niveau du circuit primaire.

6. Convertisseur (1) selon la revendication précédente, dans lequel le composant magnétique est configuré pour que :

   - sur une première partie d'une période de fonctionnement du convertisseur, une première partie (L11) du circuit primaire transfère une énergie vers une première partie (L12) du circuit secondaire et une deuxième partie (L21) du circuit primaire réalise une inductance stockant de l'énergie ;
   - sur une deuxième partie de la période de fonctionnement du convertisseur, la deuxième partie (L21) du circuit primaire transfère une énergie vers une deuxième partie (L12) du circuit secondaire, et la première partie (L11) du circuit primaire réalise une inductance stockant de l'énergie.

7. Convertisseur (1) selon les revendications 5 ou 6, dans lequel le circuit primaire du composant magnétique (31) comprend un enroulement primaire (33) et le circuit secondaire du composant magnétique (31) comprend au moins un premier enroulement secondaire (35a) et au moins un deuxième enroulement secondaire (35b) non couplés magnétiquement entre eux, lesdits premier (35a) et deuxième (35b) enroulements secondaires étant couplés magnétiquement à l'enroulement primaire (33).

8. Convertisseur (1) selon la revendication 7, dans lequel le composant magnétique (31) est configuré pour agir comme un transformateur depuis l'enroulement primaire (33), soit vers le ou les premiers enroulements secondaires (35a), soit vers le ou les deuxièmes enroulements secondaires (35b) ; tout en fonctionnant comme une impédance qui stocke de l'énergie au niveau de l'enroulement primaire (33).

9. Convertisseur (1) selon la revendication 6, dans lequel le composant magnétique comprend au moins un premier (T1) et un deuxième (T2) transformateurs en série dans lesquels :

   - le primaire (L11) du premier transformateur (T1) forme la première partie du circuit primaire et le secondaire (L12) du premier transformateur (T1) forme la première partie du circuit secondaire ;
   - le primaire (L21) du deuxième transformateur (T2) forme la deuxième partie du circuit primaire et le secondaire (L22) du deuxième transformateur (T2) forme la deuxième partie du circuit secondaire.

10. Dispositif (10) de conversion de tension comprenant une combinaison d'au moins deux convertisseurs DC/DC isolés (1) selon l'une des revendications précédentes ; et dans lequel les premiers bras respectifs des convertisseurs DC/DC isolés sont configurés pour fonctionner avec un déphasage de $2\pi/n$, et les deuxièmes bras respectifs des convertisseurs sont configurés pour fonctionner avec un déphasage de $\pi/n$, n étant le nombre de convertisseurs DC/DC isolés (1).

11. Dispositif (10) selon la revendication 10 comprenant des convertisseurs (1) selon la revendication 4, dans lequel les convertisseurs DC/DC isolés (1) partagent un seul circuit (5) destiné à implémenter la première boucle, de sorte que les premiers bras respectifs des convertisseurs DC/DC isolés reçoivent la même consigne (I2cons).

12. Procédé de conversion de tension comprenant les étapes consistant à :

- fournir au moins un convertisseur DC/DC isolé (1) selon l'une quelconque des revendications 1 à 9 ;
- réaliser des successions d'ouverture et de fermeture des interrupteurs permettant de convertir une tension d'entrée en une tension de sortie par l'intermédiaire du composant magnétique (31) du convertisseur DC/DC isolé,

procédé dans lequel la réalisation des successions d'ouverture et de fermeture des interrupteurs comprend la modification d'un paramètre électrique d'un signal parcourant l'inductance (L2), le rapport cyclique ($\alpha_B$) du deuxième bras (B) restant sensiblement constant, de préférence sensiblement égal à 50%.

13. Procédé selon la revendication 12, dans lequel la conversion de la tension d'entrée en tension de sortie comprend une première boucle asservissant la consigne (I2cons) d'un paramètre électrique d'un signal parcourant le premier bras (A) à une différence entre la valeur (Vout_mes) de la tension de sortie du convertisseur DC/DC isolé (1) et une consigne (V*) de tension de sortie du convertisseur DC/DC isolé (1).

14. Procédé selon la revendication 12 ou 13 comprenant la fourniture d'une pluralité de convertisseurs DC/DC isolés (1); et dans lequel :

- les deuxièmes bras respectifs des convertisseurs DC/DC isolés fonctionnent avec un déphasage de $\pi/n$, n étant le nombre de convertisseurs DC/DC isolés; et
- les premiers bras respectifs des convertisseurs DC/DC isolés fonctionnent avec un déphasage de $2\pi/n$.

15. Procédé selon les revendications 13 et 14, dans lequel la conversion de la tension d'entrée en tension de sortie est réalisée avec la même consigne (I2cons) délivrée par un seul premier bras (A) partagé entre les convertisseurs DC/DC isolés.

**Patentansprüche**

1. Isolierter Gleichspannungswandler (1), umfassend:

- einen ersten Arm (A), umfassend Schalter (MA1, MA2) in Reihe, wobei der erste Arm (A) mit dem Eingang des Wandlers verbunden ist,
- einen zweiten Arm (B), umfassend Schalter (MB1, MB2) in Reihe,
- eine Induktanz (L2), die zwischen den Mittelpunkten des ersten (A) und des zweiten Arms (B) angeschlossen ist,
- eine Kapazität (C1), die zwischen den Endklemmen des zweiten Arms (B) angeschlossen ist,
- einen dritten Arm (C), umfassend ein magnetisches Bauteil (31), wobei der dritte Arm (C) am Mittelpunkt des zweiten Arms (B) angeschlossen ist,

wobei Abfolgen von Öffnen und von Schließen der Schalter (MA1, MA2, MB1, MB2) erlauben, mittels des magnetischen Bauteils (31) eine Eingangsspannung (Ue) in eine Ausgangsspannung (Vout) umzuwandeln.

2. Wandler (1) nach Anspruch 1, wobei der erste Arm (A) konfiguriert ist, um die Ausgangsspannung (Vout) des isolierten Gleichspannungswandlers (1) durch Ändern eines elektrischen Signals, das die Induktanz (L2) durchläuft, zu steuern, wobei das Tastverhältnis ($\alpha_B$) des zweiten Arms (B) etwa konstant bleibt.

3. Wandler (1) nach vorangehendem Anspruch, wobei der zweite Arm (B) derart konfiguriert ist, dass sein Tastverhältnis ($\alpha_B$) bei etwa 50 % liegt.

4. Wandler (1) nach einem der vorangehenden Ansprüche, umfassend einen Schaltkreis (5), der bestimmt ist, eine erste Schleife derart zu implementieren, dass ein Sollwert (I2cons) eines elektrischen Parameters eines Signals, das die Induktanz (L2) durchläuft, die zwischen dem ersten und zweiten Arm (B) angeschlossen ist, auf eine Differenz zwischen dem Wert (Vout_mes) der Ausgangsspannung des isolierten Gleichspannungswandlers (1) und einem Ausgangsspannungs-Sollwert (V*) des isolierten Gleichspannungswandlers (1) eingestellt wird.

5. Wandler (1) nach einem der vorangehenden Ansprüche, wobei das magnetische Bauteil einen primären Schaltkreis und einen sekundären Schaltkreis aufweist, die durch eine elektrische Isolationsbarriere getrennt sind, wobei das magnetische Bauteil konfiguriert ist, um bei der Umwandlung einer Eingangsspannung (Ue) des isolierten Gleichspannungswandlers (1) in eine Ausgangsspannung (Uout) wie ein Transformator des primären Schaltkreises in Richtung des sekundären Schaltkreises und wie eine Impedanz, welche Energie im Bereich des primären Schaltkreises speichert, zu funktionieren.

**6.** Wandler (1) nach vorangehendem Anspruch, wobei das magnetische Bauteil konfiguriert ist, damit:

- über einen ersten Teil eines Betriebszeitraums des Wandlers, ein erster Teil (L11) des primären Schaltkreises eine Energie in Richtung eines ersten Teils (L12) des sekundären Schaltkreises transferiert und ein zweiter Teil (L21) des primären Schaltkreises eine Induktanz realisiert, die Energie speichert,
- über einen zweiten Teil eines Betriebszeitraums des Wandlers, der zweite Teil (L21) des primären Schaltkreises eine Energie in Richtung eines zweiten Teils (L12) des sekundären Schaltkreises transferiert und der erste Teil (L11) des primären Schaltkreises eine Induktanz realisiert, die Energie speichert.

**7.** Wandler (1) nach den Ansprüchen 5 oder 6, wobei der primäre Schaltkreis des magnetischen Bauteils (31) eine primäre Wicklung (33) umfasst und der sekundäre Schaltkreis des magnetischen Bauteils (31) mindestens eine erste sekundäre Wicklung (35a) und mindestens eine zweite sekundäre Wicklung (35b) umfasst, die untereinander nicht magnetisch gekoppelt sind, wobei die erste (35a) und zweite (35b) sekundäre Wicklung mit der primären Wicklung (33) magnetisch gekoppelt sind.

**8.** Wandler (1) nach Anspruch 7, wobei das magnetische Bauteil (31) konfiguriert ist, um ab der primären Wicklung (33) entweder in Richtung der ersten sekundären Wicklung(en) (35a) oder in Richtung der zweiten sekundären Wicklung(en) (35b) wie ein Transformator zu agieren und dabei wie eine Impedanz zu funktionieren, die Energie im Bereich der primären Wicklung (33) speichert.

**9.** Wandler (1) nach Anspruch 6, wobei das magnetische Bauteil mindestens einen ersten (T1) und einen zweiten (T2) Transformator in Reihe umfasst, wobei:

- der Primäre (L11) des ersten Transformators (T1) den ersten Teil des primären Schaltkreises bildet und der Sekundäre (L12) des ersten Transformators (T1) den ersten Teil des sekundären Schaltkreises bildet,
- der Primäre (L21) des zweiten Transformators (T2) den zweiten Teil des primären Schaltkreises bildet und der Sekundäre (L22) des zweiten Transformators (T2) den zweiten Teil des sekundären Schaltkreises bildet,

**10.** Vorrichtung (10) zur Umwandlung von Spannung, umfassend eine Kombination von mindestens zwei isolierten Gleichspannungswandlern (1) nach einem der vorangehenden Ansprüche; und wobei die jeweiligen ersten Arme der isolierten Gleichspannungswandler konfiguriert sind, um mit einer Phasenverschiebung von $2\pi/n$ zu funktionieren, und die jeweiligen zweiten Arme der Wandler konfiguriert sind, um mit einer Phasenverschiebung von $\pi/n$ zu funktionieren, wobei n die Anzahl der isolierten Gleichspannungswandler (1) ist.

**11.** Vorrichtung (10) nach Anspruch 10, umfassend Wandler (1) nach Anspruch 4, wobei sich die isolierten Gleichspannungswandler (1) einen einzigen Schaltkreis (5) teilen, der bestimmt ist, die erste Schleife zu implementieren, so dass die jeweiligen ersten Arme der isolierten Gleichspannungswandler den gleichen Sollwert (I2cons) erhalten.

**12.** Verfahren zur Umwandlung von Spannung, umfassend die Schritte, die darin bestehen:

- Bereitstellen mindestens eines isolierten Gleichspannungswandlers (1) nach einem der Ansprüche 1 bis 9,
- Durchführen von Abfolgen von Öffnen und von Schließen der Schalter, die erlauben, mittels des magnetischen Bauteils (31) des isolierten Gleichspannungswandlers eine Eingangsspannung in eine Ausgangsspannung umzuwandeln,

wobei bei dem Verfahren das Durchführen von Abfolgen von Öffnen und von Schließen der Schalter das Ändern eines elektrischen Parameters eines Signals umfasst, das die Induktanz (L2) durchläuft, wobei das Tastverhältnis ($\alpha_B$) des zweiten Arms (B) etwa konstant, vorzugsweise bei etwa 50 %, bleibt.

**13.** Verfahren nach Anspruch 12, wobei die Umwandlung der Eingangsspannung in Ausgangsspannung eine erste Schleife umfasst, welche den Sollwert (I2cons) eines elektrischen Parameters eines Signals, das den ersten Arm (A) durchläuft, auf eine Differenz zwischen dem Wert (Vout_mes) der Ausgangsspannung des isolierten Gleichspannungswandlers (1) und einem Ausgangsspannungs-Sollwert (V*) des isolierten Gleichspannungswandlers (1) einstellt.

**14.** Verfahren nach einem der Ansprüche 12 oder 13, umfassend das Bereitstellen einer Vielzahl von isolierten Gleichspannungswandlern (1) und wobei:

- die jeweiligen zweiten Arme der isolierten Gleichspannungswandler mit einer Phasenverschiebung von $\pi/n$ funktionieren, wobei n die Anzahl isolierter Gleichspannungswandler (1) ist, und
- die jeweiligen ersten Arme der isolierten Gleichspannungswandler mit einer Phasenverschiebung von $2\pi/n$ funktionieren.

15. Verfahren nach den Ansprüchen 13 und 14, wobei die Umwandlung der Eingangsspannung in Ausgangsspannung mit dem gleichen Sollwert (I2cons) durchgeführt wird, der von einem einzigen, zwischen den isolierten Gleichspannungswandlern geteilten ersten Arm (A) bereitgestellt wird.

**Claims**

1. Isolated DC-DC converter (1) comprising:

   - a first arm (A) comprising switches (MA1, MA2) in series, the first arm (A) being connected to the input of the converter;
   - a second arm (B) comprising switches (MB1, MB2) in series;
   - an inductor (L2) connected between the midpoints of the first (A) and second (B) arms;
   - a capacitor (C1) connected between the end terminals of the second arm (B);
   - a third arm (C) comprising a magnetic component (31), the third arm (C) being connected to the midpoint of the second arm (B);

   wherein successions of opening and closing of the switches (MA1, MA2, MB1, MB2) make it possible to convert an input voltage (Ue) into an output voltage (Vout) via the magnetic component (31).

2. Converter (1) according to claim 1, wherein the first arm (A) is configured to control the output voltage (Vout) of the isolated DC-DC converter (1) by modifying an electrical parameter of a signal passing through the inductor (L2), the duty factor ($\alpha_B$) of the second arm (B) remaining substantially constant.

3. Converter (1) according to the preceding claim, wherein the second arm (B) is configured so that its duty factor ($\alpha_B$) is substantially equal to 50%.

4. Converter (1) according to any of the preceding claims, comprising a circuit (5) intended to implement a first loop so as to slave a set point (I2cons) of an electrical parameter of a signal passing through the inductor (L2) connected between the first and second arms (B) to a difference between the value (Vout_mes) of the output voltage of the isolated DC-DC converter (1) and an output-voltage set point (V*) of the isolated DC-DC converter (1).

5. Converter (1) according to any of the preceding claims, wherein the magnetic component comprises a primary circuit and a secondary circuit separated by an electrical isolation barrier, said magnetic component being configured so as, during the conversion of an input voltage (Ue) of the isolated DC-DC converter (1) into an output voltage (Uout), to function as a transformer from the primary circuit to the secondary circuit and as an impedance that stores energy in the primary circuit.

6. Converter (1) according to the preceding claim, wherein the magnetic component is configured so that:

   - over a first part of an operating period of the converter, a first part (L11) of the primary circuit transfers energy to a first part (L12) of the secondary circuit and a second part (L21) of the primary circuit implements an inductor storing energy;
   - over a second part of the operating period of the converter, the second part (L21) of the primary circuit transfers energy to a second part (L12) of the secondary circuit, and the first part (L11) of the primary circuit implements an inductor storing energy.

7. Converter (1) according to claim 5 or claim 6, wherein the primary circuit of the magnetic component (31) comprises a primary winding (33) and the secondary circuit of the magnetic component (31) comprises at least one first secondary winding (35a) and at least one secondary winding (35b), not coupled magnetically with each other, said first (35a) and second (35b) secondary windings being coupled magnetically to the primary winding (33).

8. Converter (1) according to claim 7, wherein the magnetic component (31) is configured to act as a transformer from the primary winding (33), either to the first secondary winding or windings (35a), or to the second secondary winding or windings (35b); while functioning as an impedance that stores energy in the primary winding (33).

9. Converter (1) according to claim 6, wherein the magnetic component comprises at least one first (T1) and one second (T2) transformer in series, wherein:

   - the primary (L11) of the first transformer (T1) forms a first part of the primary circuit and the secondary (L12) of the first transformer (T1) forms the first part of the secondary circuit;
   - the primary (L21) of the second transformer (T2) forms the second part of the primary circuit and the secondary (L22) of the second transformer (T2) forms the second part of the secondary circuit.

10. Voltage conversion device (10) comprising a combination of at least two isolated DC-DC converters (1) according to any of the preceding claims; and wherein the respective first arms of the isolated DC-DC converters are configured to function with a phase difference of $2\pi/n$, and the respective second arms of the converters are configured to function with a phase difference of $\pi/n$, n being the number of isolated DC-DC converters (1).

11. Device (10) according to claim 10, comprising converters (1) according to claim 4, wherein the isolated DC-DC converters (1) share a single circuit (5) intended to implement the first loop, so that the respective first arms of the isolated DC-DC converters receive the same set point (I2cons).

12. Voltage conversion method comprising the steps consisting of:

    - providing at least one isolated DC-DC converter (1) according to any of claims 1 to 9;
    - performing successions of opening and closing of the switches making it possible to convert an input voltage into an output voltage via a magnetic component (31) of the isolated DC-DC converter;

method in which the performance of successions of opening and closing of the switches comprises the modification of a first electrical parameter of a signal passing through the inductor (L2), the duty factor ($\alpha_B$) of the second arm (B) remaining substantially constant, preferably substantially equal to 50%.

13. Method according to claim 12, wherein the conversion of the input voltage into an output voltage comprises a first loop slaving the set point (I2cons) of an electrical parameter of a signal passing through the first arm (A) to a difference between the value (Vout_mes) of the output voltage of the isolated DC-DC converter (1) and an output-voltage set point (V*) of the isolated DC-DC converter (1).

14. Method according to claim 12 or claim 13, comprising the provision of a plurality of isolated DC-DC converters (1); and wherein:

    - the respective second arms of the isolated DC-DC converters function with a phase difference of $\pi/n$, n being the number of isolated DC-DC converters; and
    - the respective first arms of the isolated DC-DC converters function with a phase difference of $2\pi/n$.

15. Method according to claim 13 and claim 14, wherein the conversion of the input voltage into an output voltage is performed with the same set point (I2cons) delivered by a single first arm (A) shared between the isolated DC-DC converters.

Figure 1

Figure 2

Figure 3

Figure 4

Figure 5

Figure 6a

Figure 6b

Figure 6c

Figure 6d

Figure 6e

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5754413 A
- FR 1458573